# EUROPEAN PATENT SPECIFICATION

(11) **EP 3 330 866 B1**
(45) Date of publication and mention of the grant of the patent: **06.11.2024**
(21) Application number: 17197872.9
(22) Date of filing: 23.10.2017
(51) Int. Cl.: G06F 15/78, G06F 9/46

(54) **METHODS AND APPARATUS FOR PROGRAMMABLE INTEGRATED CIRCUIT COPROCESSOR SECTOR MANAGEMENT**
VERFAHREN UND VORRICHTUNG FÜR PROGRAMMIERBARE INTEGRIERTE SCHALTUNG EINER COPROZESSOR-SEKTOR-VERWALTUNG
PROCÉDÉS ET APPAREIL DE GESTION DE SECTEUR DE COPROCESSEUR À CIRCUIT INTÉGRÉ PROGRAMMABLE

(30) Priority: 22.11.2016 US 201615358665
(43) Date of publication of application: 06.06.2018
(73) Proprietor: INTEL Corporation, Santa Clara, CA 95054 (US)
(72) Inventor: DASU, Aravind, San Jose, CA 95134 (US); WEBER, Scott, San Jose, CA 95134 (US); TAN, Jun Pin, 11900 Bayan Lepas, Penang (MY); RAHMAN, Arifur, San Jose, CA 95134 (US)
(74) Representative: Goddar, Heinz J.

(56) References cited:
- WO-A1-01/84323
- US-A1- 2012 275 715
- US-A1- 2013 162 290
- US-A1- 2014 165 021
- US-A1- 2014 176 187
- US-A1- 2016 321 094
- US-B1- 7 930 661
- US-B1- 9 425 802

## Description

### Background

This relates to integrated circuits and, more particularly, to programmable integrated circuits.

Programmable integrated circuits are a type of integrated circuit that can be programmed by a user to implement a desired custom logic function. In a typical scenario, a logic designer uses computer-aided design tools to design a custom logic circuit. When the design process is complete, the computer-aided design tools generate configuration data. The configuration data is loaded into memory elements to configure the devices to perform the functions of the custom logic circuit.

Configuration data may be supplied to a programmable device in the form of a configuration bit stream. After a first configuration bit stream has been loaded onto a programmable device, the programmable device may be reconfigured by loading a different configuration bit stream in a process known as reconfiguration. An entire set of configuration data is often loaded during reconfiguration.

Programmable devices may be used for coprocessing in big-data or fast-data applications. For example, programmable devices may be used in application acceleration tasks in a datacenter and may be reprogrammed during datacenter operation to perform different tasks. However, the speed of reconfiguration of programmable devices is traditionally several orders of magnitude slower than the desired rate of virtualization in datacenters. Moreover, on-chip caching or buffering of prefetched configuration bit-streams to hide the latency of reconfiguration is undesirably expensive in terms of silicon real estate. Additionally, repeated fetching of configuration bit-streams from off-chip storage via the entire configuration circuit chain is energy intensive.

Situations frequently arise where it would be desirable to design and implement programmable devices with improved reconfiguration speed, reduced energy consumption, and parallel reconfiguration capabilities.

It is within this context that the embodiments herein arise.

US 2012/275715 A1 discloses an image data processing apparatus, an image data processing method and a computer readable medium. The image data processing apparatus includes a configuration selecting unit, a loading unit, and a controller. The configuration selecting unit determines types of image characteristics of individual processing units in image data and selects plural pieces of circuit configuration data for individual processing units. The loading unit predicts a predetermined number of pieces of circuit configuration data in descending order of the likelihood of being selected for the processing unit currently being processed, and loads, before selection of the circuit configuration data for the processing unit, the predetermined number of pieces of configuration data into a circuit configuration memory for a reconfigurable circuit. If the selected circuit configuration data has already been loaded, the controller causes the circuit configuration to be reconfigured. If the selected circuit configuration data has not been loaded, the controller causes the selected circuit configuration data to be loaded and the circuit configuration to be reconfigured.

US 2016/0321094 A1 provides a virtualization platform for Network Functions Virtualization (NFV). The virtualization platform may include a host processor coupled to an acceleration coprocessor. The acceleration coprocessor may be a reconfigurable integrated circuit to help provide improved flexibility and agility for the NFV. The coprocessor may include multiple virtual function hardware acceleration modules each of which is configured to perform a respective accelerator function. A virtual machine running on the host processor may wish to perform multiple accelerator functions in succession at the coprocessor on a given data. In one suitable arrangement, intermediate data output by each of the accelerator functions may be fed back to the host processor. In another suitable arrangement, the successive function calls may be chained together so that only the final resulting data is fed back to the host processor.

### Summary

The invention is defined by the subject matter of the independent claims. Advantageous embodiments are subject to the dependent claims and are described below.

A host processor may be tasked to perform a pool of jobs/tasks. In order to improve the speed at which these tasks are performed, a coprocessor integrated circuit can be used to perform a subset of the pool of tasks. The host processor sends an acceleration request to the coprocessor. This acceleration request is received by a secure device manager in the coprocessor, which identifies one or more logic sectors that are available to perform one or more given tasks associated with the acceleration request.

During an execution phase, the secure device manager communicates with logic sector managers at each of the logic sectors to determine whether any of the logic sectors are already configured to carry out the given task. If it is determined that such a pre-configured sector exists, that sector may be selected and used to execute the given task.

If it is determined that such a pre-configured sector does not exist, the host processor may provide the logic sector manager of an available sector with a pointer to the location of the configuration bit stream required for performing the given task that is stored in a stacked memory die. However, in some cases, the required configuration bit stream may not be present in the stacked memory die. The logic sector manager may determine whether the required configuration data is present in the stacked memory die.

If it is determined that the required configuration data is stored in the stacked memory die, the required configuration bit stream is retrieved from the stacked memory die and is used to reconfigure the available sector. The configuration data stored on the stacked memory die may be unencrypted. The stacked memory die may act as an instruction cache from which configuration data are fetched by the logic sector managers for reconfiguring the logic sectors.

If it is determined that the required configuration data is not stored in the stacked memory die, the logic sector manager of the available sector sends a request to the host processor asking the host processor to provide the required configuration bit stream to the stacked memory die. The logic sector manager may then load the required configuration bit stream onto the available sector, thereby reconfiguring the available sector. In some scenarios, the logic sector manager receives the required configuration bit stream from the host processor directly through the secure device manager, in which case the required configuration bit stream may also be stored on the stacked memory die.

A coprocessor integrated circuit may perform steps for load balancing jobs/tasks received from a host processor. A host processor may send an nondeterministic job/task with a predetermined time budget to the coprocessor. Some tasks provided to the coprocessor may be deterministic in that they will take a predetermined amount of time to complete. In contrast, other tasks provided to the coprocessor may be nondeterministic in that it is not possible to predict the number of steps required to complete each task.

The coprocessor may analyze the received task and may allocate an initial number of logic sectors to attempt to complete the task within the required time budget. The coprocessor may monitor the duration for the task while the task is being performed by the initially allocated logic sectors. While monitoring the duration of the task, the coprocessor may determine that the initially allocated logic sectors will not be able to complete the job within the required time budget.

In response to determining that the time budget cannot be adhered to with just the initially allocated logic sectors, the coprocessor may introduce more parallelism by dynamically allocating additional sectors to help process the task. In particular, idle sectors or sectors handling less critical tasks may be recruited/borrowed and reconfigured to perform the time-sensitive task. In some embodiments, the maximum number of concurrently (e.g., simultaneously) running sectors may optionally be limited.

Further features of the invention, its nature and various advantages will be more apparent from the accompanying drawings and following detailed description.

### Brief Description of the Drawings

FIG. 1 is a diagram of an illustrative programmable integrated circuit in accordance with an embodiment.
FIG. 2 is a diagram showing how configuration data is created by a logic design system and loaded into a programmable device to configure the device for operation in a system.
FIG. 3 is a diagram showing how a programmable integrated circuit may be used as a coprocessor in support of a host processor in accordance with an embodiment.
FIG. 4 is a diagram of an illustrative programmable integrated circuit having multiple logic sectors managed by logic sector managers and a secure device manager in accordance with an embodiment.
FIG. 5 is an illustrative integrated circuit package that includes a coprocessor programmable integrated circuit and one or more in-package stacked memory elements in accordance with an embodiment.
FIG. 6 is a flow chart of illustrative steps for loading configuration bit streams into the logic sectors of the programmable integrated circuit of FIG. 4 in accordance with an embodiment.
FIG. 7 is a flow chart of illustrative steps for performing logic sector management for the programmable integrated circuit of FIG. 4 to handle acceleration requests received from a host processor in accordance within an embodiment.
FIG. 8 is a flow chart of illustrative steps for performing load balancing for the programmable integrated circuit of FIG. 4 to handle fixed time budget job requests received from a host processor.

### Detailed Description

Embodiments of the present invention relate to integrated circuits and, more particularly, to programmable integrated circuits.

Programmable integrated circuits use programmable memory elements to store configuration data. Configuration data may be generated based on source code corresponding to application-specific tasks to be performed in parallel on the programmable integrated circuit. During programming of a programmable integrated circuit, configuration data is loaded into the memory elements. The memory elements may be organized in arrays having numerous rows and columns. For example, memory array circuitry may be formed in hundreds or thousands of rows and columns on a programmable logic device integrated circuit.

During normal operation of the programmable integrated circuit, each memory element provides a static output signal. The static output signals that are supplied by the memory elements serve as control signals. These control signals are applied to programmable logic on the integrated circuit to customize the programmable logic to perform a desired logic function.

It may sometimes be desirable to configure or reconfigure the programmable integrated circuit as an accelerator circuit to efficiently perform parallel processing tasks. The accelerator circuit may include multiple columns soft processors of various types that are specialized for different types of parallel tasks. The accelerator circuit may be dynamically reconfigured to optimally assign and perform the parallel tasks.

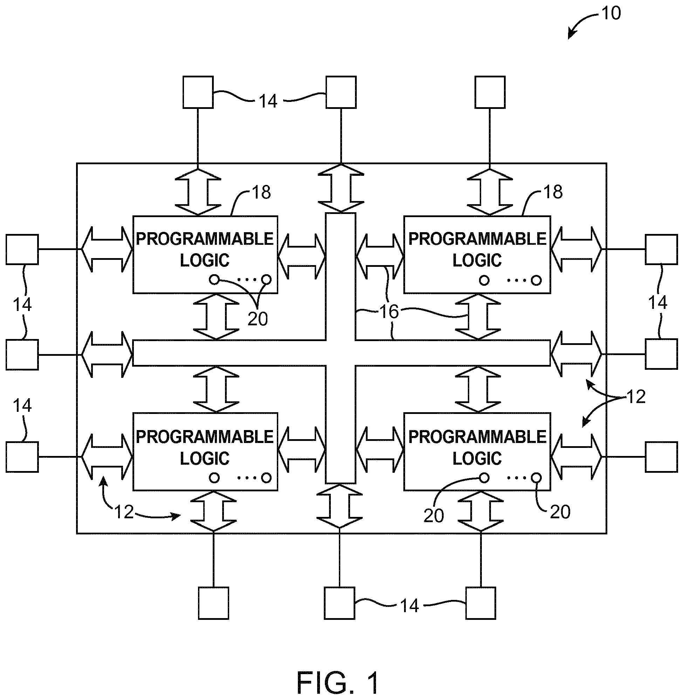

An illustrative programmable integrated circuit such as programmable logic device (PLD) 10 is shown in FIG. 1. As shown in FIG. 1, programmable integrated circuit 10 may have input-output circuitry 12 for driving signals off of device 10 and for receiving signals from other devices via input-output pins 14. Interconnection resources 16 such as global and local vertical and horizontal conductive lines and buses may be used to route signals on device 10. Interconnection resources 16 include fixed interconnects (conductive lines) and programmable interconnects (i.e., programmable connections between respective fixed interconnects). Programmable logic 18 may include combinational and sequential logic circuitry. The programmable logic 18 may be configured to perform a custom logic function.

Programmable integrated circuit 10 contains memory elements 20 that can be loaded with configuration data (also called programming data) using pins 14 and input-output circuitry 12. Once loaded, the memory elements 20 may each provide a corresponding static control output signal that controls the state of an associated logic component in programmable logic 18. Typically, the memory element output signals are used to control the gates of metal-oxide-semiconductor (MOS) transistors. Some of the transistors may be p-channel metal-oxide-semiconductor (PMOS) transistors. Many of these transistors may be n-channel metal-oxide-semiconductor (NMOS) pass transistors in programmable components such as multiplexers. When a memory element output is high, an NMOS pass transistor controlled by that memory element will be turned on to pass logic signals from its input to its output. When the memory element output is low, the pass transistor is turned off and does not pass logic signals.

A typical memory element 20 is formed from a number of transistors configured to form cross-coupled inverters. Other arrangements (e.g., cells with more distributed inverter-like circuits) may also be used. With one suitable approach, complementary metal-oxide-semiconductor (CMOS) integrated circuit technology is used to form the memory elements 20, so CMOS-based memory element implementations are described herein as an example. In the context of programmable integrated circuits, the memory elements store configuration data and are therefore sometimes referred to as configuration random-access memory (CRAM) cells.

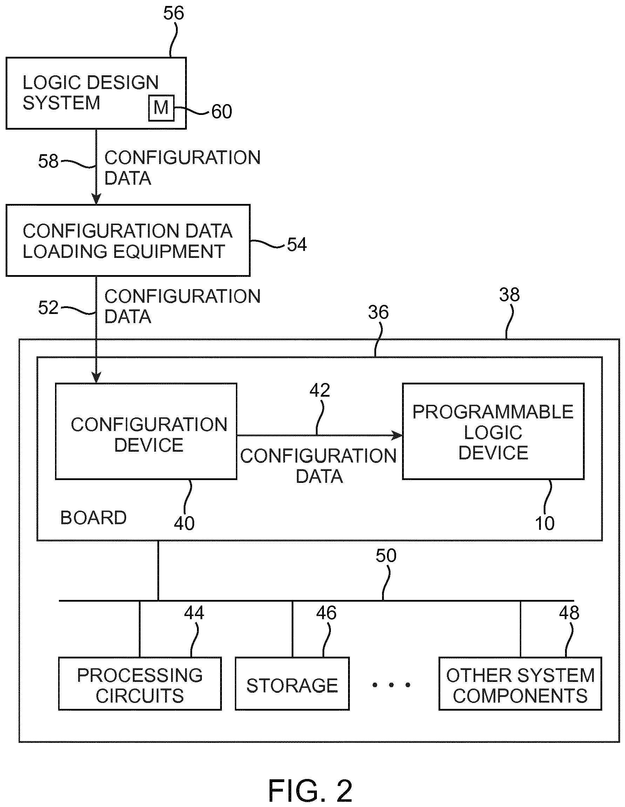

An illustrative system environment for device 10 is shown in FIG. 2. Device 10 may be mounted on a board 36 in a system 38. In general, programmable logic device 10 may receive configuration data from programming equipment or from other suitable equipment or device. In the example of FIG. 2, programmable logic device 10 is the type of programmable logic device that receives configuration data from an associated integrated circuit 40. With this type of arrangement, circuit 40 may, if desired, be mounted on the same board 36 as programmable logic device 10.

Circuit 40 may be an erasable-programmable read-only memory (EPROM) chip, a programmable logic device configuration data loading chip with built-in memory (sometimes referred to as a "configuration device"), or another suitable device. When system 38 boots up (or at another suitable time), the configuration data for configuring the programmable logic device may be supplied to the programmable logic device from device 40, as shown schematically by path 42. The configuration data that is supplied to the programmable logic device may be stored in the programmable logic device in its configuration random-access-memory elements 20.

System 38 may include processing circuits 44, storage 46, and other system components 48 that communicate with device 10. The components of system 38 may be located on one or more boards such as board 36 or other suitable mounting structures or housings and may be interconnected by buses, traces, and other electrical paths 50.

Configuration device 40 may be supplied with the configuration data for device 10 over a path such as path 52. Configuration device 40 may, for example, receive the configuration data from configuration data loading equipment 54 or other suitable equipment that stores this data in configuration device 40. Device 40 may be loaded with data before or after installation on board 36.

It can be a significant undertaking to design and implement a desired logic circuit in a programmable logic device. Logic designers therefore generally use logic design systems based on computer-aided-design (CAD) tools to assist them in designing circuits. A logic design system can help a logic designer design and test complex circuits for a system. When a design is complete, the logic design system may be used to generate configuration data for electrically programming the appropriate programmable logic device.

As shown in FIG. 2, the configuration data produced by a logic design system 56 may be provided to equipment 54 over a path such as path 58. The equipment 54 provides the configuration data to device 40, so that device 40 can later provide this configuration data to the programmable logic device 10 over path 42. Logic design system 56 may be based on one or more computers and one or more software programs. In general, software and data may be stored on any computer-readable medium (storage) in system 56 and is shown schematically as storage 60 in FIG. 2.

In a typical scenario, logic design system 56 is used by a logic designer to create a custom circuit design. The system 56 produces corresponding configuration data which is provided to configuration device 40. Upon power-up, configuration device 40 and data loading circuitry on programmable logic device 10 is used to load the configuration data into CRAM cells 20 of device 10. Device 10 may then be used in normal operation of system 38.

After device 10 is initially loaded with a set of configuration data (e.g., using configuration device 40), device 10 may be reconfigured by loading a different set of configuration data. Sometimes it may be desirable to reconfigure only a portion of the memory cells on device 10 via a process sometimes referred to as partial reconfiguration. As memory cells are typically arranged in an array, partial reconfiguration can be performed by writing new data values only into selected portion(s) in the array while leaving portions of array other than the selected portion(s) in their original state.

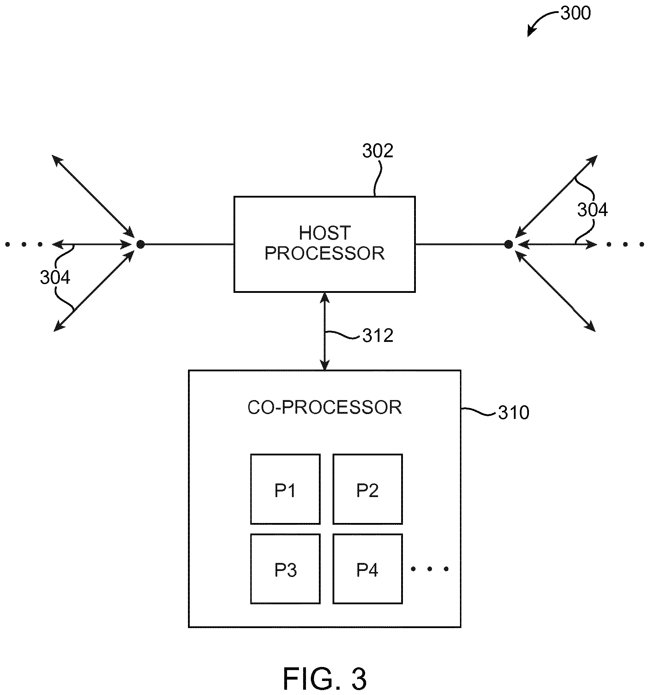

Partial reconfiguration may be a particularly useful feature when developing an acceleration framework. For example, consider a scenario in which a system such as system 300 includes a host processor 302 that is coupled to other network components via paths 304 (see, e.g., FIG. 3). As shown in FIG. 3, host processor 302 is coupled to a coprocessor (e.g., an accelerator circuit) such as coprocessor 310 (sometimes referred to herein as accelerator circuit 310, or accelerator 310) via path 312. Accelerator circuit 310 may be a programmable integrated circuit such as device 10 of FIG. 1 or alternatively, multiple accelerator circuits may be in a programmable integrated circuit. Accelerator circuit 310 may include various processing nodes (e.g., processing cores, processor cores) such as cores P1-P4 to help accelerate the performance of host processor 302. Cores P1-P4 may be soft processor cores or soft processors that are configurable (e.g., programmable). In some instances, processor cores such as cores P1-P4 may be implemented as logic sectors in accelerator circuit 310.

Configured as such, accelerator circuit 310 may sometimes be referred to as a "hardware accelerator." As examples, the processing cores on the coprocessor may be used to accelerate a variety of functions, which may include but are not limited to: encryption, Fast Fourier transforms, video encoding/decoding, convolutional neural networks (CNN), firewalling, intrusion detection, database searching, domain name service (DNS), load balancing, caching network address translation (NAT), and other suitable network packet processing applications, just to name a few.

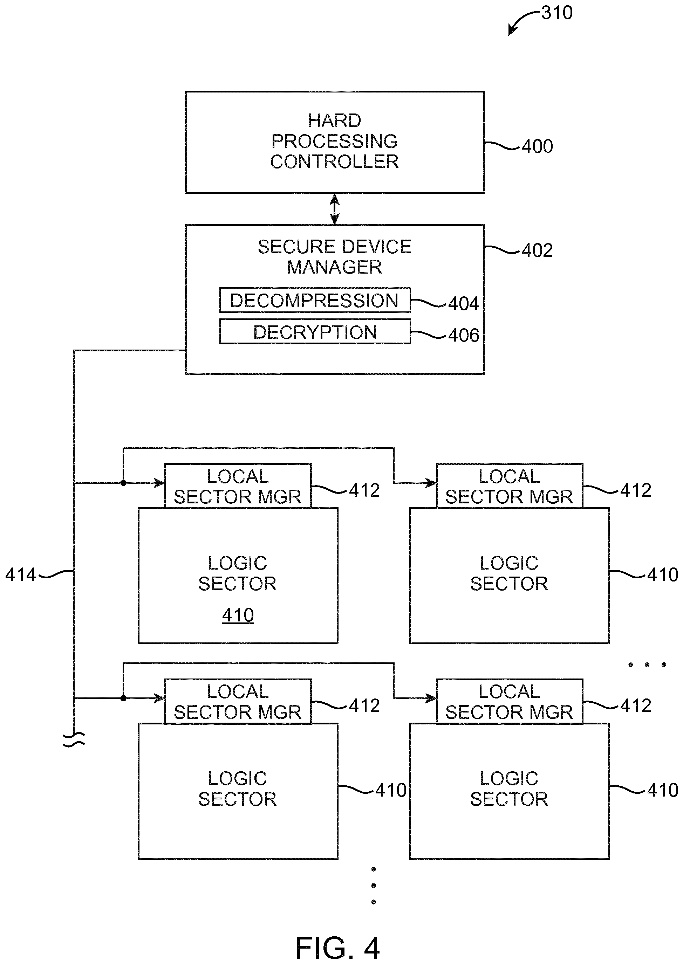

For instances in which cores P1-P4 are implemented as logic sectors in accelerator circuit 310, each logic sector may be managed using logic sector managers, which may in turn be managed using a secure device manager. As shown in FIG. 4, accelerator circuit 310 may include multiple logic sectors 410 (sometimes referred to as sectors 410). Each logic sector may be managed by a respective one of logic sector managers (LSM) 412. Logic sector managers 412 may be managed by secure device manager 402. Hard processing controller 400 may receive configuration data (e.g., configuration bit streams) and/or accelerator requests from a host processor (e.g., host processor 302 of FIG. 3). Secure device manager 402 may receive the configuration data, the accelerator requests, and commands from hard processing controller 400. Hard processing controller 400 may, for instance, be a microprocessor. Secure device manager 402 may provide commands, configuration data, and acceleration requests to logic sector managers 412 over a bus 414.

In some instances, the configuration data and accelerator requests may optionally be compressed and encrypted. Thus, secure device manager 402 may include decompression engine 404 and decryption engine 406 for decompressing and decrypting data received from the host processor through hard processing controller 400.

Logic sectors 410 are individually configurable/programmable. This allows each of logic sectors 410 to independently process different tasks in parallel. The parallel processing enabled by logic sectors 410 may be utilized to perform application acceleration (e.g., in a datacenter) for a variety of tasks or jobs simultaneously by reconfiguring different subsets of the logic sectors to perform said tasks.

In order to efficiently manage application acceleration as new tasks are issued to accelerator circuit 310 from the host processor, it may be necessary to perform real-time reconfiguration on any of logic sectors 410 that will be used to process a given newly received task. In other words, reconfiguration of logic sectors 410 may be performed while accelerator circuit 310 is running and may be performed without interrupting the operation of accelerator circuit 310.

The selection of which of logic sectors 410 are to be used for a given task may be determined by identifying which sectors are idle (e.g., not presently performing a task) and by identifying which sectors are handling lower-priority tasks (e.g., tasks without a fixed time budget) compared to the priority of the given task. Some or all of logic sectors 410 that are identified as being idle or as performing less critical tasks may then be selected, and if necessary, reconfigured to perform operations of the given task. Reassignment of logic sectors 410 that are working on a lower-priority task than the given task in need of sector assignment may be performed based on a load-balancing mechanism. It should be noted that those logic sectors 410 that are identified as already being configured to perform the given task may be given selection priority over any sectors that would need to be reconfigured to perform said task.

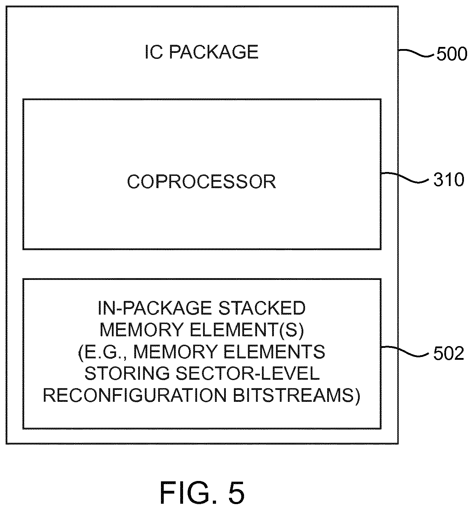

Configuration data received by accelerator circuit 310 may be stored in memory on the same circuit package as accelerator circuit 310. As shown in FIG. 5, coprocessor 310 and one or more in-package stacked memory elements 502 (sometimes referred to as memory element 502 or memory die 502) are integrated as part of an IC package 500.

In some instances, memory die 502 is mounted on accelerator circuit 310 directly. Memory die 502 may be connected to accelerator circuit 310 through through-silicon vias (TSVs) that pass through one or more silicon layers of the circuit die of accelerator circuit 310. These TSVs may allow memory die 502 to load configuration data onto sectors 410 of accelerator circuit 310 up to three orders of magnitude faster than traditional reconfiguration techniques.

Configuration data from the host processor may be loaded onto memory die 502 after undergoing processing/routing through secure device manager 402 of accelerator circuit 310 (e.g., after undergoing decompression and decryption). The configuration data may include one or more sector-level reconfiguration bit streams. When one of sectors 410 is selected to perform a task, if that sector needs to be reconfigured to perform the task (e.g., because the sector is presently configured to perform a different task), then secure device manager 402 may provide the selected sector with a pointer to the location of the necessary configuration bit stream (e.g., persona) required to perform that task in memory die 502.

In some scenarios, the memory die 502 may not already have the necessary configuration bit stream stored when said bit stream is needed by the selected sector. In this case, secure device manager 402 may retrieve the necessary configuration bit stream from external memory and may load the retrieved bit stream onto the selected sector and onto memory die 502.

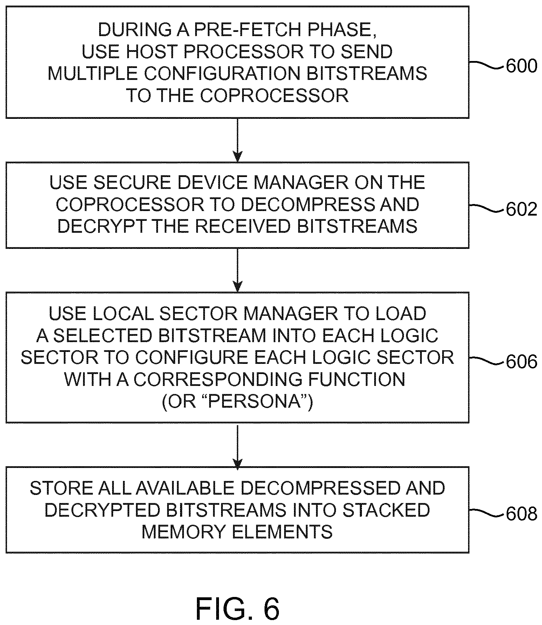

Accelerator circuit 310 and memory elements 502 described above in connection with FIGS. 3-5 may perform steps for receiving and storing configuration bit streams from a host processor during a pre-fetch phase of an instruction cycle (see, e.g., illustrative steps of FIG. 6).

At step 600, a pre-fetch phase may be initiated by a host processor (e.g., host processor 302 of FIG. 3) for a set of anticipated configuration bit streams (e.g., corresponding to processing tasks). These configuration bit streams may be provided to a coprocessor (e.g., accelerator circuit 310 of FIGS. 3-5).

At step 602, a secure device manager within the coprocessor (e.g., secure device manager 402 of FIG. 4) may receive the configuration bit streams from the host processor and may perform decompression and decryption operations on the received bit streams.

At step 606, logic sector managers within the coprocessor (e.g., logic sector managers 412 of FIG. 4) may be used to load selected bit streams into each logic sector to configure each logic sector with a corresponding function or *"*persona*"* (e.g., to configure each logic sector to perform a particular task).

At step 608, all available decompressed and decrypted configuration bit streams may be stored into one or more in-package stacked memory elements (e.g., memory elements 502 of FIG. 5).

By storing decompressed and decrypted configuration bit streams in in-package stacked memory elements in this way, these bit streams may be readily accessed for reconfiguring logic sectors with greater speed and power efficiency compared to traditional methods in which configuration bit streams are only retrieved from off-chip storage.

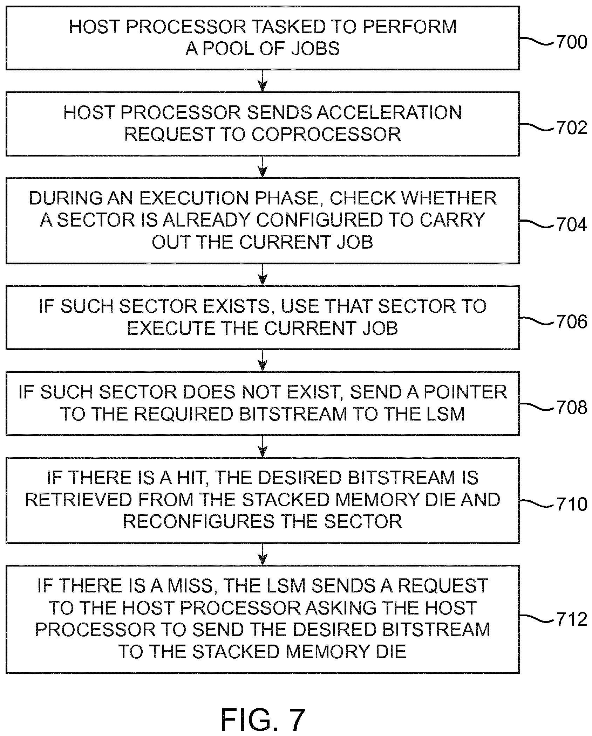

Accelerator circuit 310 and memory elements 502 described above in connection with FIGS. 3-5 may perform steps for managing sectors to perform a pool of jobs/tasks received from a host processor (see, e.g., illustrative steps of FIG. 7).

At step 700, a host processor (e.g., host processor 302 of FIG. 3) may be tasked to perform a pool of jobs/tasks. In order to improve the speed at which these tasks are performed (e.g., to accelerate the tasks), a coprocessor (e.g., accelerator circuit 310 of FIGS. 3-5) may be used to perform at least a subset of the pool of tasks.

At step 702, the host processor sends an acceleration request to the coprocessor. This acceleration request may be received by a secure device manager (e.g., secure device manager 402 of FIG. 4), which may identify one or more logic sectors (e.g., of logic sectors 410 of FIG. 4) that are available to perform one or more given tasks (e.g., current jobs) associated with the acceleration request.

At step 704, during an execution phase of the instruction cycle, the secure device manager communicates with logic sector managers (e.g., logic sector managers 412 of FIG. 4) at each of the logic sectors to determine whether any of the logic sectors are already configured to carry out the given task. Depending on whether a sector exists that is pre-configured to carry out the given task, the process may proceed to either step 706 or step 708.

At step 706, if such a pre-configured sector exists, that sector may be selected and used to execute the given task.

At step 708, if such a pre-configured sector does not exist, the host processor may provide a logic sector manager of an available sector with a pointer to the location of the configuration bit stream required for performing the given task that is stored in a stacked memory die (e.g., memory die 502 of FIG. 5). Configuration data stored on the stacked memory die may be unencrypted. However, it is possible that the required configuration bit stream will not be present in the stacked memory die. Thus, the logic sector manager may check to determine whether the required configuration data is present in the stacked memory die. If the required configuration data is present in the stacked memory die, then the process may proceed to step 710. Otherwise, the process may proceed to step 712.

At step 710, if the required configuration data is stored in the stacked memory die (e.g., if there is a cache hit), the required or desired configuration bit stream may be retrieved from the stacked memory die and may be used to reconfigure the available sector (e.g., by loading the required configuration bit stream onto the available sector). The configuration image stored in the stacked memory die may not be encrypted. The stacked memory die may act as an instruction cache from which configuration data (e.g., bit streams) are fetched by the logic sector managers for reconfiguring the logic sectors.

At step 712, if the required configuration data is not stored in the stacked memory die (e.g., if there is a cache miss), the logic sector manager of the available sector sends a request to the host processor asking the host processor to provide the required configuration bit stream to the stacked memory die. The logic sector manager may then load the required configuration bit stream onto the available sector, thereby reconfiguring the available sector. In some scenarios, the logic sector manager receives the required configuration bit stream from the host processor directly through the secure device manager, in which case the required configuration bit stream may also be stored on the stacked memory die.

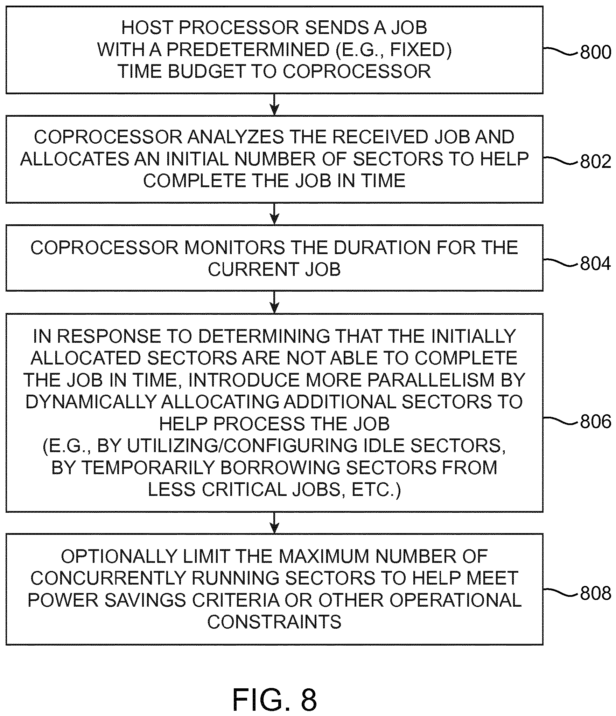

Accelerator circuit 310 described above in connection with FIGS. 3-5 may perform steps for load balancing jobs/tasks received from a host processor (see, e.g., illustrative steps of FIG. 8).

At step 800, a host processor (e.g., host processor 302 of FIG. 3) may send an nondeterministic job/task with a predetermined (e.g., fixed) time budget to a coprocessor (e.g., accelerator circuit 310 of FIGS. 3-5). Some tasks provided to the coprocessor may be deterministic in that they will take a predetermined amount of time to complete. In contrast, other tasks provided to the coprocessor may be nondeterministic in that it is not possible to predict the number of steps required to complete each task (e.g., due to iterative conditional loops). Thus, the amount of processing power, and therefore the number of logic sectors, required to perform a nondeterministic task given a fixed time budget may need to be dynamically controlled in order to ensure that the task can be completed within the time budget.

At step 802, the coprocessor may analyze the received task and may allocate an initial number of logic sectors (e.g., logic sectors 410 of FIG. 4) to attempt to complete the task within the required time budget.

At step 804, the coprocessor may monitor the duration for the task while it is being performed by the initially allocated logic sectors. While monitoring the duration of the task, the coprocessor may determine that the initially allocated logic sectors will not be able to complete the job within the required time budget.

At step 806, in response to determining that the time budget cannot be adhered to with just the initially allocated logic sectors, the coprocessor may introduce more parallelism by dynamically allocating additional sectors to help process the task. In particular, idle sectors or sectors handling less critical tasks may be recruited/borrowed and reconfigured to perform the time-sensitive task.

By prioritizing time-critical tasks in this way, the overall efficiency of the coprocessor may be advantageously increased compared to traditional coprocessor methods that lack load balancing functionality.

At step 808, the maximum number of concurrently (e.g., simultaneously) running sectors may optionally be limited. This limitation may help the coprocessor meet power savings criteria or other operational constraints. The steps of FIGS. 7 and 8 can be used together and are not mutually exclusive.

The embodiments thus far have been described with respect to integrated circuits. The methods and apparatuses described herein may be incorporated into any suitable circuit. For example, they may be incorporated into numerous types of devices such as programmable logic devices, application specific standard products (ASSPs), and application specific integrated circuits (ASICs). Examples of programmable logic devices include programmable arrays logic (PALs), programmable logic arrays (PLAs), field programmable logic arrays (FPLAs), electrically programmable logic devices (EPLDs), electrically erasable programmable logic devices (EEPLDs), logic cell arrays (LCAs), complex programmable logic devices (CPLDs), and field programmable gate arrays (FPGAs), just to name a few.

The programmable logic device described in one or more embodiments herein may be part of a data processing system that includes one or more of the following components: a processor; memory; IO circuitry; and peripheral devices. The data processing can be used in a wide variety of applications, such as computer networking, data networking, instrumentation, video processing, digital signal processing, or any suitable other application where the advantage of using programmable or reprogrammable logic is desirable. The programmable logic device can be used to perform a variety of different logic functions. For example, the programmable logic device can be configured as a processor or controller that works in cooperation with a system processor. The programmable logic device may also be used as an arbiter for arbitrating access to a shared resource in the data processing system. In yet another example, the programmable logic device can be configured as an interface between a processor and one of the other components in the system. In one embodiment, the programmable logic device may be one of the family of devices owned by ALTERA/INTEL Corporation.

The foregoing is merely illustrative of the principles of this invention and various modifications can be made by those skilled in the art. The foregoing embodiments may be implemented individually or in any combination.

## Claims

1. A system, comprising:
a host processor (302) tasked to perform a job and configured to generate a corresponding acceleration request for accelerating the job;
a coprocessor (310) configured to receive the acceleration request from the host processor (302); and
a memory die (502) connected to the coprocessor (310), wherein the coprocessor (310) comprises a plurality of logic sectors (410), wherein the logic sectors (410) are individually configurable;
wherein:
the memory die (502) is stacked on the coprocessor (310) and both are provided in the same circuit package;
the coprocessor (310) further comprises a logic sector manager (412) configured to retrieve a configuration bit stream from the memory die (502) and to configure a selected one of the plurality of logic sectors (410) with the retrieved configuration bit stream, and
the coprocessor (310) further comprises a secure device manager (402) configured to provide, if a required configuration bit stream for configuring the selected one of the plurality of logic sectors (410) is not available in the memory die (502), the required configuration bit stream to the logic sector manager (412) to facilitate said configuration of the selected one of the plurality of logic sectors (410) by the logic sector manager (412),
wherein, if the required configuration data is not stored in the memory die (502), the logic sector manager sends a request to the host processor (302) asking the host processor (302) to provide the required configuration bit stream to the memory die (502), and
wherein the logic sector manager (412) is configured to receive a pointer from the host processor (302), and to determine whether the required configuration bit stream is stored in the memory die (502) based on the pointer, and the logic sector manager (412) is configured to receive the configuration bit stream from the memory die (502) through the through-silicon vias if the required configuration bit stream is stored in the memory die (502), and to receive required configuration bit stream from the host processor (302) if the required configuration bit stream is not stored in the memory die (502).

2. The system of claim 1, wherein the coprocessor (310) and the memory die (502) are connected through the through-silicon vias for retrieving the configuration bit stream from the memory die (502).

3. The system of claim 1 or 2, wherein additional configuration bit stream is provided from the host processor (302) and the logic sector manager (412) is configured to store the required configuration bit stream in the memory die (502).

4. The system of any one of claims 1-3, wherein the secure device manager (402) includes a decompression circuit (404) for decompressing the required configuration bit stream, or a decryption circuit (406) for decrypting the required configuration bit stream.

5. The system of any one of claims 1-3, wherein the configuration bit streams stored in the memory die (502) are not encrypted.

## Patentansprüche

1. System, das Folgendes umfasst:
einen Host-Prozessor (302), der die Aufgabe hat, einen Auftrag durchzuführen, und dafür ausgebildet ist, eine entsprechende Beschleunigungsanforderung zur Beschleunigung des Auftrags zu erzeugen;
einen Coprozessor (310), der dafür ausgebildet ist, die Beschleunigungsanforderung vom Host-Prozessor (302) zu empfangen; und
einen Speicherchip (502), der mit dem Coprozessor (310) verbunden ist, wobei der Coprozessor (310) eine Vielzahl von Logiksektoren (410) umfasst, wobei die Logiksektoren (410) individuell konfigurierbar sind;
wobei:
der Speicherchip (502) auf dem Coprozessor (310) gestapelt ist und beide in der gleichen Schaltung bereitgestellt sind;
der Coprozessor (310) ferner einen Logiksektormanager (412) umfasst, der dafür ausgebildet ist, einen Konfigurationsbitstrom von dem Speicherchip (502) abzurufen und einen ausgewählten der Vielzahl von Logiksektoren (410) mit dem abgerufenen Konfigurationsbitstrom auszubilden, und
der Coprozessor (310) ferner einen sicheren Gerätemanager (402) umfasst, der ausgebildet ist, um, wenn ein erforderlicher Konfigurationsbitstrom zum Ausbilden des aus der Vielzahl von Logiksektoren (410) ausgewählten Sektors in dem Speicherchip (502) nicht verfügbar ist, den erforderlichen Konfigurationsbitstrom an den Logiksektormanager (412) bereitzustellen, um die Konfiguration des aus der Vielzahl von Logiksektoren (410) ausgewählten Sektors durch den Logiksektormanager (412) zu erleichtern,
wobei, wenn die erforderlichen Konfigurationsdaten nicht in dem Speicherchip (502) gespeichert sind, der Logiksektormanager eine Anforderung an den Host-Prozessor (302) sendet und den Host-Prozessor (302) auffordert, den erforderlichen Konfigurationsbitstrom für den Speicherchip (502) bereitzustellen, und
wobei der Logiksektormanager (412) ausgebildet ist, um einen Zeiger von dem Host-Prozessor (302) zu empfangen und auf der Grundlage des Zeigers zu bestimmen, ob der erforderliche Konfigurationsbitstrom in dem Speicherchip (502) gespeichert ist, und der Logiksektormanager (412) ausgebildet ist, um den Konfigurationsbitstrom von dem Speicherchip (502) durch die Siliziumdurchkontaktierungen zu empfangen, wenn der erforderliche Konfigurationsbitstrom in dem Speicherchip (502) gespeichert ist, und um den erforderlichen Konfigurationsbitstrom von dem Host-Prozessor (302) zu empfangen, wenn der erforderliche Konfigurationsbitstrom nicht in dem Speicherchip (502) gespeichert ist.

2. System nach Anspruch 1, wobei der Coprozessor (310) und der Speicherchip (502) durch die Siliziumdurchkontaktierungen verbunden sind, um den Konfigurationsbitstrom aus dem Speicherchip (502) abzurufen.

3. System nach Anspruch 1 oder 2, wobei ein zusätzlicher Konfigurationsbitstrom vom Host-Prozessor (302) bereitgestellt wird und der Logiksektormanager (412) dafür ausgebildet ist, den erforderlichen Konfigurationsbitstrom in dem Speicherchip (502) zu speichern.

4. System nach einem der Ansprüche 1 bis 3, wobei der sichere Gerätemanager (402) eine Dekompressionsschaltung (404) zum Dekomprimieren des erforderlichen Konfigurationsbitstroms oder eine Entschlüsselungsschaltung (406) zum Entschlüsseln des erforderlichen Konfigurationsbitstroms einschließt.

5. System nach einem der Ansprüche 1 bis 3, wobei die in dem Speicherchip (502) gespeicherten Konfigurationsbitströme nicht verschlüsselt sind.

## Revendications

1. Système comprenant :
un processeur hôte (302) chargé d'effectuer un travail et configuré pour générer une demande d'accélération correspondante pour accélérer le travail ;
un coprocesseur (310) configuré pour recevoir la demande d'accélération en provenance du processeur hôte (302) ; et
une puce mémoire (502) connectée au coprocesseur (310), le coprocesseur (310) comprenant une pluralité de secteurs logiques (410), les secteurs logiques (410) étant configurables individuellement ;
la puce mémoire (502) étant empilée sur le coprocesseur (310) et les deux étant disposés dans le même boîtier de circuit ;
le coprocesseur (310) comprenant en outre un gestionnaire de secteur logique (412) configuré pour récupérer un flux de bits de configuration de la puce mémoire (502) et pour configurer l'un sélectionné de la pluralité de secteurs logiques (410) avec le flux de bits de configuration récupéré, et
le coprocesseur (310) comprenant en outre un gestionnaire de dispositif de sécurité (402) configuré pour, si un flux de bits de configuration requis pour configurer celui de la pluralité de secteurs logiques (410) qui est sélectionné n'est pas disponible dans la puce mémoire (502), fournir le flux de bits de configuration requis au gestionnaire de secteurs logiques (412) pour faciliter ladite configuration de celui de la pluralité de secteurs logiques (410) qui est sélectionné par le gestionnaire de secteur logique (412),
dans lequel, si les données de configuration requises ne sont pas stockées dans la puce mémoire (502), le gestionnaire de secteur logique envoie au processeur hôte (302) une requête demandant au processeur hôte (302) de fournir le flux de bits de configuration requis à la puce mémoire (502), et
dans lequel le gestionnaire de secteur logique (412) est configuré pour recevoir un pointeur en provenance du processeur hôte (302), et pour déterminer si le flux de bits de configuration requis est stocké dans la puce mémoire (502) en fonction du pointeur, et le gestionnaire de secteur logique (412) est configuré pour recevoir le flux de bits de configuration en provenance de la puce mémoire (502) à travers les vias débouchants en silicone si le flux de bits de configuration requis est stocké dans la puce mémoire (502), et pour recevoir un flux de bits de configuration requis en provenance du processeur hôte (302) si le flux de bits de configuration requis n'est pas stocké dans la puce mémoire (502).

2. Système selon la revendication 1, dans lequel le coprocesseur (310) et la puce mémoire (502) sont connectés à travers les vias débouchants en silicone pour récupérer le flux de bits de configuration à partir de la puce de mémoire (502).

3. Système selon la revendication 1 ou 2, dans lequel un flux de bits de configuration additionnel est fourni par le processeur hôte (302) et le gestionnaire de secteur logique (412) est configuré pour stocker le flux de bits de configuration requis dans la puce mémoire (502) .

4. Système selon l'une quelconque des revendications 1 à 3, dans lequel le gestionnaire de dispositif de sécurité (402) inclut un circuit de décompression (404) pour décompresser le flux de bits de configuration requis, ou un circuit de déchiffrement (406) pour déchiffrer le flux de bits de configuration requis.

5. Système selon l'une quelconque des revendications 1 à 3, dans lequel les flux de bits de configuration stockés dans la puce mémoire (502) ne sont pas chiffrés.
